# EUROPÄISCHE PATENTSCHRIFT

(11) **EP 3 101 079 B1**
(45) Veröffentlichungstag und Bekanntmachung des Hinweises auf die Patenterteilung: **23.10.2019**
(21) Anmeldenummer: 16169335.3
(22) Anmeldetag: 12.05.2016
(51) Int. Cl.: C09J 163/00, C09K 3/10

(54) **WASSERDAMPFSPERRENDE KLEBEMASSE MIT ANPOLYMERISIERTEM EPOXIDSIRUP**
STEAM BLOCKING ADHESIVE WITH ANPOLYMERISED EPOXIDE SYRUP
MASSE COLLANTE FORMANT BARRIERE A LA VAPEUR D'EAU COMPRENANT UN SIROP EPOXYDE PRE-POLYMERISE

(30) Priorität: 04.06.2015 DE 102015210345
(43) Veröffentlichungstag der Anmeldung: 07.12.2016
(73) Patentinhaber: tesa SE, 22848 Norderstedt (DE)
(72) Erfinder: Keite-Telgenbüscher, Dr. Klaus, 22529 Hamburg (DE); Schuh, Dr. Christian, 22767 Hamburg (DE); Graucob, Annalena, 21224 Rosengarten (DE)

(56) Entgegenhaltungen:
- DE-A1-102012 202 377

## Beschreibung

Die vorliegende Erfindung betrifft eine wasserdampfsperrende Klebemasse, enthaltend eine Klebstoffbasis aus mindestens einem Epoxidsirup, mindestens einem Elastomer, mindestens einem Initiator, optional mindestens einem Klebharz und optional mindestens einem weiteren Reaktivharz sowie optional ein Lösungsmittel, ein Klebeband mit dieser wasserdampfsperrenden Klebemasse sowie die Verwendung einer solchen Klebemasse oder eines solchen Klebebandes.

Zur Verkapselung feuchtigkeitsempfindlicher organischer Aufbauten wie z.B. organischer Leuchtdioden (OLEDs) werden spezielle Barriereklebemassen, die auch als wasserdampfsperrende Klebemassen bezeichnet werden, verwendet. Eine gute Klebemasse für die Versiegelung von (opto-)elektronischen Bauteilen weist eine geringe Permeabilität gegen Sauerstoff und insbesondere gegen Wasserdampf auf, hat eine ausreichende Haftung auf der Anordnung und kann gut auf diese auffließen. Eine geringe Haftung auf der Anordnung verringert die Barrierewirkung an der Grenzfläche, wodurch ein Eintritt von Sauerstoff und Wasserdampf unabhängig von den Eigenschaften der Klebmasse ermöglicht wird. Nur wenn der Kontakt zwischen Masse und Substrat durchgängig ist, sind die Masseeigenschaften der bestimmende Faktor für die Barrierewirkung der Klebemasse.

Zur Charakterisierung der Barrierewirkung werden üblicherweise die Sauerstofftransmissionsrate OTR (Oxygen Transmission Rate) sowie die Wasserdampftransmissions¬rate WVTR (Water Vapor Transmission Rate) angegeben. Die jeweilige Rate gibt dabei den flächen- und zeitbezogenen Fluss von Sauerstoff be¬ziehungsweise Wasserdampf durch einen Film unter spezifischen Bedingungen von Temperatur und Partialdruck sowie gegebenenfalls weiterer Messbedingungen wie relativer Luftfeuchtigkeit an. Je geringer diese Werte sind, desto besser ist das jeweilige Material zur Kapselung geeignet. Die Angabe der Permeation basiert dabei nicht allein auf den Werten für WVTR oder OTR, sondern beinhaltet immer auch eine Angabe zur mittleren Weglänge der Permeation wie zum Beispiel die Dicke des Materials oder eine Normalisierung auf eine bestimmte Weglänge.

Als wasserdampfsperrende oder Barriereklebemassen werden im Stand der Technik zur Randverkapselung aktuell häufig Epoxidflüssigkleber verwendet. Für die flächige Verkapselung bieten sich Haftklebstoffe / Tapes an. Dazu werden den flüssigen Epoxiden Polymere und Klebharze zugesetzt, sodass die Formulierungen haftklebrig werden. Versuche haben gezeigt, dass die Barriereperformance mit dem Anteil an Epoxidharz steigt.

Da die Barriereperformance mit dem Anteil an Epoxid im Tape steigt, ist es also wünschenswert hohe Epoxidanteile zu realisieren. Das Problem dabei ist jedoch, dass das Epoxid flüssig ist und somit mit steigendem Epoxidanteil die haftklebrigen Eigenschaften abnehmen und schließlich sogar verschwinden. Aus diesem Grund sind aktuelle Barriereklebemassen in ihrem Epoxidgehalt begrenzt. Typischerweise wird die Viskosität von Epoxidharzen auf Epichlorhydrinbasis über das Verhältnis von Epichlorhydrin zu beispielsweise Bisphenol-A und einer daraus resultierenden leichten Molekulargewichtserhöhung eingestellt ["Epoxy Adhesive Formulations" 2006, E. M. Petrie, S.30ff]. Der Nachteil ist ein aufgrund des Herstellprozesses hoher Halogengehalt, der in Anwendungen in der Elektronikindustrie nicht geduldet wird. Durch Destillation lässt sich zwar das Epoxid aufreinigen (z.B. Epikote 828 LVEL) jedoch funktioniert dies nur mit destillierbaren (flüssigen) Epoxiden von denen wiederum keine hohen Anteile ins Tape formuliert werden können, da es sonst flüssig ist. Eine weitere Möglichkeit sind sogenannte b-staged Epoxidsysteme. Dabei handelt es sich um Epoxidsysteme, die bereits leicht anvernetzt und somit nicht mehr flüssig sind. Der große Nachteil dieser Systeme ist jedoch, dass sie gekühlt ausgeliefert werden müssen, da die Vernetzungsreaktion sonst fortschreitet und die Epoxide vollständig vernetzen.

Speziellere Epoxidmonomere wie beispielsweise Epoxycyclohexyl-Derivate, die nicht über die Epichlorhydrinroute hergestellt werden, sind häufig sehr flüssig. Ein Beispiel hierfür ist Uvacure 1500.

Es besteht daher Bedarf nach Epoxiden, die zwar unvernetzt sind, aber trotzdem eine ausreichend hohe Viskosität aufweisen, um eine Barriereklebemasse bereitstellen zu können, die trotz guter wasserdampfsperrender Eigenschaften eine hohe Haftklebrigkeit aufweist. Ferner sollten die Epoxide mit erhöhter Viskosität über einen anderen als den Epichlorhydrin-Weg erhalten werden.

Die AU 758128 B2 beschreibt lagerstabile kationisch härtende multifunktionelle Epoxidabmischungen. Um zu erreichen, dass die multifunktionellen Epoxidharze lagerstabil sind, ist es nach dieser Schrift erforderlich, eine ungewollte vorzeitige Polymerisation zu vermeiden. Dies wird erreicht, indem bei der Polymerisation von multifunktionellen Epoxidmonomeren 0,0005 bis 10 Gew.-% eines organischen und/oder anorganischen Erdalkali- oder Alkalimetallverbindung zugegeben werden. Eine Polymerisation vor gewünschter Vernetzung soll also in jedem Fall vermieden werden. Neben der erfindungsgemäßen Stabilisierung dieser Klebmassen geht aus dieser Schrift hervor, dass für kationisch härtbare Flüssigkleber Epoxycyclohexylderivate besonders bevorzugt sind, so dass es wünschenswert wäre, auch aus diesem Monomer hochviskose Epoxide herstellen zu können.

Die SG 160949 B schlägt vor, Di-Epoxide mit Di-Isocyanaten zu reagieren. Aus dieser Mischung bilden sich cyclische Trimere (Isocyanurate) und Oxazolidinone mit einem M_{w} < 3.000g/mol und einer niedrigen Polydispersität, die man dann wie Epoxide aushärten kann. Dabei ist erforderlich, dass mindestens difunktionelle Substanzen zum Einsatz kommen, da andernfalls keine reaktiven Gruppen für die nachfolgende Aushärtung zur Verfügung stünden. Die entstehenden Verbindungen weisen jedoch niedrige Viskositäten auf.

Die DE 10 2012 202377 A1 offenbart wasserdampfsperrende Klebemassen mit einer niedrigen Wasserdampfpermeationsrate enthaltend ein Reaktivharz, ein Klebharz, ein Elastomer und einen Initiator.

Aufgabe der vorliegenden Erfindung war es daher, eine lagerfähige haftklebrige Barriereklebemasse mit besonders hohen Epoxidgehalten (>50%) bei gleichzeitig sehr niedrigen Halogengehalten herzustellen, die zur Verkapselung organischer Elektronik verwendet werden kann.

Gelöst wird die Aufgabe durch eine wasserdampfsperrende Klebemasse gemäß Anspruch 1, bei der die Klebstoffbasis ohne Lösungsmittel eine Wasserdampfpermeationsrate nach der Aktivierung der Reaktivharzkomponente von weniger als 100 g/m²d, bevorzugt von weniger als 60 g/m²d, insbesondere weniger als 30 g/m²d aufweist, wobei der Epoxidsirup bis-Epoxidmonomere und aus diesen erzeugte hochmolekulare unvernetzte Polyepoxide enthält.

Überraschenderweise wurde gefunden, dass diese besondere Kombination aus bis-Epoxidmonomeren und hochmolekularen unvernetzten Polyepoxiden eine hohe Viskosität der Barriereklebemasse ermöglicht bei gleichbleibend guten wasserdampfsperrenden Eigenschaften. Die so hergestellten wasserdampfsperrenden Klebemassen lassen sich aufgrund ihrer Viskosität gut verarbeiten sind gut handhabbar und einfach applizierbar.

"Hochmolekulare unvernetzte Polyepoxide" sind dabei solche, bei denen zwar eine Polymerisation der Monomere zu Polymerketten erfolgt ist, aber (im Wesentlichen) noch keine Verbindung mehrerer Polymerketten untereinander derart erfolgt ist, dass sich ein Netz hätte ausbilden können.

Vorzugsweise ist die Viskosität des resultierenden Epoxidsirups mindestens doppelt so hoch, vorzugsweise mindestens viermal so hoch und insbesondere mindestens zehnmal so hoch ist wie die des eingesetzten Epoxides im nicht-umgesetzten Zustand. Mit einer solchen Viskosität verfügt der Epoxidsirup über eine Viskosität, die es ermöglicht, dass die resultierende wasserdampfsperrende Klebemasse gute haftklebrige Eigenschaften aufweist.

Alle in dieser Anmeldung gemachten Viskositätsangaben beziehen sich, sofern nichts anderes angegeben ist, auf eine Messung bei 23°C nach DIN 53019-1.

"Epoxidsirup" bezeichnet dabei solche Epoxide, deren Viskosität mindestens 1 Pa·s (entsprechend 1.000 mPs) beträgt.

Vorzugsweise ist der Epoxidsirup in einer Menge von 10 bis 80 Gew.-%, besonders bevorzugt von 20 bis 75 Gew.-%, insbesondere von 35 bis 70 Gew.-% in der Klebstoffbasis enthalten. Es sind somit Anteile von Epoxiden in der Klebemasse möglich, die weit über das hinausgehen, was der Stand der Technik zu leisten in der Lage war, so dass sehr gute wasserdampfsperrende Eigenschaften möglich sind bei gleichzeitig bestehender ausreichender Viskosität der Klebemasse.

Besonders bevorzugt umfasst die Molgewichtsverteilung der im Epoxidsirup enthaltenen Polyepoxide mindestens den Bereich von 2.000 g/mol bis 300.000 g/mol. Das bedeutet, es liegen im Epoxidsirup Epoxidmoleküle mit sehr unterschiedlichem Molgewicht vor, von ganz gering bis sehr hoch, wobei von den niedermolekularen (< 2.000 g/mol) bis hin zu den hochmolekularen (> 300.000 g/mol) Verbindungen durchgängig alle enthalten sind. Es können auch Verbindungen mit geringerem oder noch höherem Molgewicht enthalten sein.

Besonders vorteilhaft weist der Epoxidsirup der wasserdampfsperrenden Klebemasse eine Viskosität von mindestens 50 Pa s, bevorzugt zwischen 50-800 Pa s, besonders bevorzugt zwischen 75-500 Pa s und insbesondere zwischen 100-350 Pa s auf.

Dabei wird die Viskosität nicht etwa dadurch erhalten, dass verschiedene Polymere gemischt werden, sondern dass sich aufgrund der Reaktionsbedingungen ganz unterschiedlich große Polymermoleküle bilden. Die Polydispersität D ist ein Maß für die Verteilung der Molmassen. Die Polydispersität D ist definiert als gewichtsmittleres Molekulargewicht M_{w} / zahlenmittleres Molekulargewicht Mₙ der vorhandenen Polymere. Eine großer Wert für die Polydispersität bedeutet somit eine breite Molmassenverteilung von sehr kurzkettigen bis zu langkettigen Makromolekülen, d.h. es liegen Moleküle vieler verschiedener Kettenlängen im Polymer vor.

Für die vorliegende Erfindung bedeutet dies, dass die mono-, bi- bzw. multimodale Molekulargewichtsverteilung derart ausgebildet ist, dass von niedermolekularen Bestandteilen (< 2.000 g/mol) durchgängig bis hin zu sehr hochmolekularen Bestandteilen (> 300.000 g/mol) Moleküle zu finden sind.

Charakteristisch für solch breiten Molekulargewichtsverteilungen sind Polydispersitäten der Epoxidsirupe von mindestens 3, bevorzugt mindestens 5. In vielen Fällen sind die Polydispersitäten jedoch deutlich höher. Je nach Reaktionsführung der Anpolymerisation wurden Polydispersitäten bis zu 100 erreicht.

Diese Besonderheit der Molekulargewichtsverteilung trägt insbesondere zu den erfindungsgemäß vorteilhaften Eigenschaften eines hohen Epoxidgehaltes (viele niedermolekulare Bis-Epoxide) und gleichzeitig hochviskosem Verhalten (sehr hochmolekulare Epoxide) des Produktes bei.

Besonders vorteilhaft sind in dem Epoxidsirup der wasserdampfsperrenden Klebemasse im unvernetzten Zustand mindestens 65%, bevorzugt mindestens 75%, insbesondere mindestens 80% der ursprünglichen Epoxidgruppen noch vorhanden sind, im Sirup somit ein großer Teil der Epoxideinheiten noch in der Monomerenform vorliegt. Besonders günstig ist es also, wenn im Epoxidsirup nach wie vor eine große Menge der eingesetzten multifunktionellen Epoxidmonomeren unreagiert als Monomer vorliegt und sich nur vereinzelt hochmolekulare Polyepoxide gebildet haben, die allerdings noch unvernetzt sind.

"Unvernetzter Zustand" bedeutet dabei, das Epoxidmonomere zwar zu Ketten polymerisiert sind, diese Ketten aber nicht untereinander unter Ausbildung einer Netzstruktur reagiert haben. Dies äußert sich darin, dass die erfindungsgemäßen Epoxidsirupe in geeigneten Lösungsmitteln vollständig löslich sind.

Als multifunktionelle Epoxide sind Bis-Epoxide besonders geeignet. Nach erfolgter Polymerisation steht eine weitere Epoxidgruppe zur Verfügung, die später im Epoxidklebharz die Vernetzung bewirken kann.

Als multifunktionelle Epoxide haben sich dabei Bis-Epoxycyclohexyl-Derivate, insbesondere 3,4-Epoxycyclohexylmethyl-3,4-Epoxycyclohexan Carboxylat, und Bis-Epoxide auf Basis von Bisphenol-A, Bisphenol-S oder Bisphenol-F als besonders vorteilhaft herausgestellt. Mit ihnen lassen sich Sirupe herstellen, deren Viskosität gut geeignet ist, um die Epoxide zu den gewünschten haftklebrigen wasserdampfsperrenden Klebemassen weiter zu verarbeiten.

Weiterhin ist es besonders vorteilhaft, wenn der Epoxidsirup durch Anpolymerisieren der bis-Epoxidmonomere erhalten wird. Dies bedeutet, dass die Epoxidmonomere nicht vollständig polymerisiert werden, sondern die Polymerisationsreaktion nur gestartet und nach kurzer Zeit wieder beendet wird. Dabei werden die Epoxide derart anpolymerisiert, dass hochmolekulare Polyepoxide aus z.B. Bis-Epoxymonomeren erzeugt werden, ohne dass diese vernetzen. Die so erhaltenen Epoxidsirupe sind bestens geeignet, um Epoxidklebmassen mit haftklebrigen Eigenschaften herzustellen. Wichtig ist dabei, dass die Initiation erst erfolgt, nachdem der Initiator gut verteilt im Epoxid vorliegt. Sonst liegen die reaktiven Zentren zu nah beieinander und es kommt zur Vernetzung, die in diesem Stadium noch nicht gewünscht ist. Um ein Vermischen zu erreichen, kann beispielsweise gerührt werden, aber auch andere Formen des Vermischens sind denkbar und möglich.

Weiterhin ist es vorteilhaft, wenn die Polymerisation der bis-Epoxidmonomere bei Erreichen einer gewünschten Viskosität des Epoxidsirups durch Zugabe eines Initiatorfängers gestoppt wird. Dadurch ist es möglich, die erhaltenen Epoxidsirupe für mehrere Monate lagerstabil zu machen. Selbst bei höheren Temperaturen von z.B. 80°C sind die erhaltenen Epoxidsirupe über mehrere Tage lagerstabil. Als Initiatorfänger sind ein Gemisch aus Wasser und Aceton, Lösungen von (Erd-)Alkalihydroxiden oder Lösungen von (Erd-)Alkalialkoxiden besonders geeignet. Im Falle der Verwendung eines Gemisches aus Wasser und Aceton ist ein Verhältnis der beiden Komponenten von 1:1 besonders bevorzugt.

Die Menge an Initiatorfänger sollte dabei vorzugsweise der Menge an Initiator entsprechen bzw. im Wesentlichen entsprechen. Bei der Verwendung von 7 g Initiator werden also vorteilhafter Weise auch 7 g Initiatorfänger einesetzt.

Besonders gut lässt sich das erfindungsgemäße Verfahren durchführen, wenn der Initiator für das Anpolymerisieren ausgewählt ist aus der Gruppe bestehend aus Photoinitiator und thermischem Initiator zur Initiation einer kationischen Polymerisation. Im Falle des Einsatzes eines Photoinitiators oder eines thermischen Initiators ist eine Menge von höchstens 0,1 Gew.-%, vorzugsweise höchstens 0,08 Gew.-%, insbesondere höchstens 0,05 Gew.-% besonders bevorzugt. Damit können die angestrebten Viskositäten auf besonders einfache und gut handhabbare Weise erreicht werden.

Neben diesen klassischen Initiatoren zur kationischen Epoxidhärtung sind überraschenderweise auch spezielle Isocyanate als Initiatoren für die vorliegende Erfindung besonders geeignet.

Besonders geeignet als Initiator ist dabei ein elektronenarmes Monoisocyanat, das in einer Menge von höchstens 10 Gew.-%, vorzugsweise höchstens 8 Gew.-% und insbesondere höchstens 7 Gew.-% eingesetzt wird. Die Reaktion lässt sich besonders gut kontrollieren, wenn das Monoisocyanat in einer Menge von 7 ± 0,5 Gew.-% eingesetzt wird. Geeignete Monoisocyanate sind insbesondere ausgewählt aus der Gruppe bestehend aus p-Tolylisocyanat, o-Tolylisocyanat und Sulfonylisocyanaten, dabei insbesondere p-Toluolsulfonylmethylisocyanat, o-Toluolsulfonylmethylisocyanat, 4-Chlorbenzylsulfonylisocyanat, o-Toluolsulfonylisocyanat, p-Toluolsulfonylisocyanat und Benzylsulfonylisocyanat, wobei p-Toluolsulfonylisocyanat besonders bevorzugt ist.

Als Temperaturbereich zur Durchführung der Anpolymerisierungsreaktion zur Herstellung des Epoxidsirups initiiert mit elektronenaremen Isocyanaten hat sich der Bereich zwischen 20 und 120°C, vorzugsweise zwischen 40 und 100°C, insbesondere zwischen 80 und 90°C, als besonders vorteilhaft herausgestellt.

Für thermische kationische Initiatoren werden Temperaturen entsprechend deren Initiationstemperatur oder leicht darunter gewählt.

Temperatur und Initiatormenge stehen dabei in einer Wechselwirkung. Je mehr Initiator zugesetzt wird, desto niedriger kann die Temperatur sein, um die gleiche Reaktionsgeschwindigkeit zu erreichen. Während z.B. im Falle der elektronenarmen Isocyanate 10 Gew.-% Initiator bei Raumtemperatur nur eine sehr langsame Geschwindigkeit bewirken, reicht bei 85°C eine Menge von 7 Gew.-% Initiator aus, um die Reaktion innerhalb weniger Stunden durchzuführen.

Überraschend konnte festgestellt werden, dass das vorstehend beschriebene Verfahren zur Anpolymerisation zu einer langsamen und kontrollierten Erhöhung der Viskosität während der Polymerisation führt. Obwohl es sich um multifunktionelle, insbesondere zweifach funktionelle, Epoxide handelt, die sehr schnell unlösliche hochvernetzte Netzwerke ausbilden, bleiben die mit diesem Verfahren hergestellten Epoxidklebharze überraschenderweise löslich. Dieses Verhalten wird damit erklärt, dass relativ wenige initiierende Spezies durch den Initiator wie z.B. das p-Toluolsulfonylmethylisocyanat gebildet werden, sich die wachsenden Ketten somit nicht treffen können, deswegen bei sehr niedrigen Epoxidumsätzen wenige sehr hochmolekulare Polymere gebildet werden. Die Viskositätserhöhung ist demnach auf die Bildung von sehr hochmolekularen Polyepoxiden zurückzuführen. GPC-Messungen und FT-IR Spektren unterstützen diese Theorie. Wichtig ist dabei, dass die Initiation erst erfolgt, nachdem der Initiator gut verteilt im Epoxid vorliegt, damit in diesem Stadium keine Vernetzung erfolgt.

Besonders bevorzugt sind wasserdampfsperrende Klebemassen mit viskosen Epoxidsirupen, bei denen das Epoxidmonomer 3,4-Epoxycyclohexylmethyl-3,4-Epoxycyclohexancarboxylat ist und der Anteil an Epoxidsirup größer 30 % beträgt. Für wasserdampfsperrende Klebemassen mit hohen Epoxidsirupanteilen sind besonders bevorzugt Sirupe mit einer Viskosität von mindestens 1 Pa s (1.000 mPs), bevorzugt 10 Pa s (10.000 mPs), insbesondere 25 Pa s (25.000 mPs), da auf diese Weise gut applizierbare Haftklebmassen entstehen. Für Haftklebemassen mit besonders guten Barriereeigenschaften (hohe lag-time) sind bevorzugt Epoxidsirupe mit Viskositäten von mindestens 50 Pa s, bevorzugt zwischen 50-800 Pa s, besonders bevorzugt zwischen 75-500 Pa s und insbesondere zwischen 100-350 Pa s.

Besonders geeignet ist bei einer erfindungsgemäßen wasserdampfsperrenden Klebemasse der darin enthaltene mindestens eine Epoxidsirup erhältlich durch ein Verfahren, umfassend die Schritte:
- Zugeben eines Initiators, ausgewählt aus der Gruppe bestehend aus elektronenarmem Monoisocyanat, Photoinitiator und thermischem Initiator, zu mindestens einem flüssigen bis-Epoxidmonomeren;
- Vermischen der Komponenten;
- Polymerisieren des bis-Epoxids derart, dass die Viskosität des resultierenden Epoxidsirups mindestens doppelt so hoch, vorzugsweise mindestens viermal so hoch und insbesondere mindestens zehnmal so hoch ist wie die des eingesetzten Epoxides im nicht-umgesetzten Zustand.

Des Weiteren betrifft die vorliegende Erfindung ein Klebeband enthaltend eine erfindungsgemäße wasserdampfsperrende Klebemasse. Solche Klebebänder ermöglichen eine besonders einfache Applikation.

Ein Anwendungsgebiet, für das sich die vorliegenden Epoxidsirupe bzw. die daraus hergestellte Klebemasse oder das daraus hergestellte Klebeband hervorragend eignen, ist die Verkapselung von Aufbauten in der organischen Elektronik. Aber auch unzählige weitere Anwendungen, für die eine haftklebrige wasserdampfsperrende Epoxidharzklebemasse benötigt wird, sind denkbar.

Initiatoren für die kationische Polymerisation von Epoxiden im Sinne dieser Erfindung sind alle dem Fachmann bekannten thermischen und photochemischen Initiatoren. Diese werden sowohl zur Herstellung des Epoxidsirups als auch in den erfindungsgemäßen Klebebändern verwendet.

Photoinitiatorensind beispielsweise, jedoch nicht ausschließlich:
Sulfonium-Salze (siehe zum Beispiel US 4,231,951 A, US 4,256,828 A, US 4,058,401 A, US 4,138,255 A und US 2010/063221 A1) wie Triphenylsulfoniumhexafluoroarsenat, Triphenylsulfoniumhexafluoroborat, Triphenylsulfoniumtetrafluoroborat, Triphenylsulfoniumtetrakis-(pentafluorobenzyl)-borat, Methyldiphenylsulfoniumtetrafluoroborat, Methyldiphenylsulfoniumtetrakis-(pentafluorobenzyl)-borat, Dimethylphenylsulfoniumhexafluorophosphat, Triphenylsulfoniumhexafluorophosphat, Triphenylsulfoniumhexafluoroantimonat, Diphenylnaphthylsulfoniumhexafluoroarsenat, Tritolylsulfoniumhexafluorophosphat, Anisyldiphenylsulfoniumhexafluoroantimonat, 4-Butoxyphenyldiphenylsulfoniumtetrafluoroborat, 4-Butoxyphenyldiphenylsulfoniumtetrakis-(pentafluorobenzyl)-borat, 4-Chlorophenyldiphenylsulfoniumhexafluoroantimonat, Tris-(4-phenoxyphenyl)-sulfoniumhexafluorophosphat, Di-(4-ethoxyphenyl)-methylsulfoniumhexafluoroarsenat, 4-Acetylphenyldiphenylsulfoniumtetrafluoroborat, 4-Acetylphenyldiphenylsulfoniumtetrakis-(pentafluorobenzyl)-borat, Tris-(4-thiomethoxyphenyl)-sulfoniumhexafluorophosphat, Di-(methoxysulfonylphenyl)-methylsulfoniumhexafluoroantimonat, Di-(methoxynaphthyl)-methylsulfoniumtetrafluoroborat, Di-(methoxynaphthyl)-methylsulfoniumtetrakis-(pentafluorobenzyl)-borat, Di-(carbomethoxyphenyl)-methylsulfoniumhexafluorophosphat, (4-Octyloxyphenyl)-diphenylsulfoniumtetrakis-(3,5-bis-trifluoromethylphenyl)-borat, Tris-[4-(4-acetylphenyl)-thiophenyl]-sulfoniumtetrakis-(pentafluorophenyl)-borat, Tris-(dodecylphenyl)-sulfoniumtetrakis-(3,5-bis-trifluoromethylphenyl)-borat, 4-Acetamidphenyldiphenylsulfoniumtetrafluoroborat, 4-Acetamidphenyldiphenylsulfoniumtetrakis-(pentafluorobenzyl)-borat, Dimethylnaphthylsulfoniumhexafluorophosphat, Trifluoromethyldiphenylsulfoniumtetrafluoroborat, Trifluoromethyldiphenylsulfoniumtetrakis-(pentafluorobenzyl)-borat, Phenylmethylbenzylsulfoniumhexafluorophosphat, 5-Methylthianthreniumhexafluorophosphat, 10-Phenyl-9,9-dimethylthioxantheniumhexafluorophosphat, 10-Phenyl-9-oxothioxantheniumtetrafluoroborat, 10-Phenyl-9-oxothioxantheniumtetrakis-(pentafluorobenzyl)-borat, 5-Methyl-10-oxothianthreniumtetrafluoroborat, 5-Methyl-10-oxothianthreniumtetrakis-(pentafluorobenzyl)-borat und 5-Methyl-10,10-dioxothianthreniumhexafluorophosphat oder p-Toluolsulfonylisocyanat oder lodonium-Salze (siehe zum Beispiel US 3,729,313 A, US 3,741,769 A, US 4,250,053 A, US 4,394,403 A und US 2010/063221 A1) wie Diphenyliodoniumtetrafluoroborat, Di-(4-methylphenyl)-iodoniumtetrafluoroborat, Phenyl-4-methylphenyliodoniumtetrafluoroborat, Di-(4-chlorphenyl)-iodoniumhexafluorophosphat, Dinaphthyliodoniumtetrafluoroborat, Di-(4-trifluormethylphenyl)-iodoniumtetrafluoroborat, Diphenyliodoniumhexafluorophosphat, Di-(4-methylphenyl)-iodoniumhexafluorophosphat, Diphenyliodoniumhexafluoroarsenat, Di-(4-phenoxyphenyl)-iodoniumtetrafluoroborat, Phenyl-2-thienyliodoniumhexafluorophosphat, 3,5-Dimethylpyrazolyl-4-phenyliodoniumhexafluorophosphat, Diphenyliodoniumhexafluoroantimonat, 2,2'-Diphenyliodoniumtetrafluoroborat, Di-(2,4-dichlorphenyl)-iodoniumhexafluorophosphat, Di-(4-bromphenyl)-iodoniumhexafluorophosphat, Di-(4-methoxyphenyl)-iodoniumhexafluorophosphat, Di-(3-carboxyphenyl)-iodoniumhexafluorophosphat, Di-(3-methoxycarbonylphenyl)-iodoniumhexafluorophosphat, Di-(3-methoxysulfonylphenyl)-iodoniumhexafluorophosphat, Di-(4-acetamidophenyl)-iodoniumhexafluorophosphat, Di-(2-benzothienyl)-iodoniumhexafluorophosphat, Diaryliodoniumtristrifluormethylsulfonylmethid wie Diphenyliodoniumhexafluoroantimonat, Diaryliodoniumtetrakis-(pentafluorophenyl)-borat wie Diphenyliodoniumtetrakis-(pentafluorophenyl)-borat,, (4-n-Desiloxyphenyl)-phenyliodoniumhexafluoroantimonat, [4-(2-Hydroxy-n-tetradesiloxy)-phenyl]-phenyliodoniumhexafluoroantimonat, [4-(2-Hydroxy-n-tetradesiloxy)-phenyl]-phenyliodoniumtrifluorosulfonat, [4-(2-Hydroxy-n-tetradesiloxy)-phenyl]-phenyliodoniumhexafluorophosphat, [4-(2-Hydroxy-n-tetradesiloxy)-phenyl]-phenyliodoniumtetrakis-(pentafluorophenyl)-borat, Bis-(4-tert-butylphenyl)-iodoniumhexafluoroantimonat, Bis-(4-tert-butylphenyl)-iodoniumhexafluorophosphat, Bis-(4-tert-butylphenyl)-iodoniumtrifluorosulfonat, Bis-(4-tert-butylphenyl)-iodoniumtetrafluoroborat, Bis-(dodecylphenyl)-iodoniumhexafluoroantimonat, Bis-(dodecylphenyl)-iodoniumtetrafluoroborat, Bis-(dodecylphenyl)-iodoniumhexafluorophosphat, Bis-(dodecylphenyl)-iodoniumtrifluoromethylsulfonat, Di-(dodecylphenyl)-iodoniumhexafluoroantimonat, Di-(dodecylphenyl)-iodoniumtriflat, Diphenyliodoniumbisulfat, 4,4'-Dichlorodiphenyliodoniumbisulfat, 4,4'-Dibromodiphenyliodoniumbisulfat, 3,3'-Dinitrodiphenyliodoniumbisulfat, 4,4'-Dimethyldiphenyliodoniumbisulfat, 4,4'-Bis-succinimidodiphenyliodoniumbisulfat, 3-Nitrodiphenyliodoniumbisulfat, 4,4'-Dimethoxydiphenyliodoniumbisulfat, Bis-(dodecylphenyl)-iodoniumtetrakis-(pentafluorophenyl)-borat, (4-Octyloxyphenyl)-phenyliodoniumtetrakis-(3,5-bis-trifluoromethylphenyl)-borat und (Tolylcumyl)-iodoniumtetrakis-(pentafluorophenyl)-borat oder
Ferrocenium-Salze (siehe zum Beispiel EP 542 716 B1) wie η₅-(2,4-cyclopentadien-1-yl)-[(1,2,3,4,5,6,9)-(1-methylethyl)-benzol]-eisen.

Beispiele für kommerzialisierte Photoinitiatoren sind Cyracure UVI-6990, Cyracure UVI-6992, Cyracure UVI-6974 und Cyracure UVI-6976 der Firma Union Carbide, Optomer SP-55, Optomer SP-150, Optomer SP-151, Optomer SP-170 und Optomer SP-172 der Firma Adeka, San-Aid SI-45L, San-Aid SI-60L, San-Aid SI-80L, San-Aid SI-100L, San-Aid SI-110L, San-Aid SI-150L und San-Aid SI-180L der Firma Sanshin Chemical, SarCat CD-1010, SarCat CD-1011 und SarCat CD-1012 der Firma Sartomer, Degacure K185 der Firma Degussa, Rhodorsil Photoinitiator 2074 der Firma Rhodia, CI-2481, CI-2624, CI-2639, CI-2064, CI-2734, CI-2855, CI-2823 und CI-2758 der Firma Nippon Soda, Omnicat 320, Omnicat 430, Omnicat 432, Omnicat 440, Omnicat 445, Omnicat 550, Omnicat 550 BL und Omnicat 650 der Firma IGM Resins, Daicat II der Firma Daicel, UVAC 1591 der Firma Daicel-Cytec, FFC 509 der Firma 3M, BBI-102, BBI-103, BBI-105, BBI-106, BBI-109, BBI-110, BBI-201, BBI, 301, BI-105, DPI-105, DPI-106, DPI-109, DPI-201, DTS-102, DTS-103, DTS-105, NDS-103, NDS-105, NDS-155, NDS-159, NDS-165, TPS-102, TPS-103, TPS-105, TPS-106, TPS-109, TPS-1000, MDS-103, MDS-105, MDS-109, MDS-205, MPI-103,, MPI-105, MPI-106, MPI-109, DS-100, DS-101, MBZ-101, MBZ-201, MBZ-301, NAI-100, NAI-101, NAI-105, NAI-106, NAI-109, NAI-1002, NAI-1003, NAI-1004, NB-101, NB-201, NDI-101, NDI-105, NDI-106, NDI-109, PAI-01, PAI-101, PAI-106, PAI-1001, PI-105, PI-106, PI-109, PYR-100, SI-101, SI-105, SI-106 und SI-109 der Firma Midori Kagaku, Kayacure PCI-204, Kayacure PCI-205, Kayacure PCI-615, Kayacure PCI-625, Kayarad 220 und Kayarad 620, PCI-061T, PCI-062T, PCI-020T, PCI-022T der Firma Nippon Kayaku, TS-01 und TS-91 der Firma Sanwa Chemical, Deuteron UV 1240 der Firma Deuteron, Tego Photocompound 1465N der Firma Evonik, UV 9380 C-D1 der Firma GE Bayer Silicones, FX 512 der Firma Cytec, Silicolease UV Cata 211 der Firma Bluestar Silicones und Irgacure 250, Irgacure 261, Irgacure 270, Irgacure PAG 103, Irgacure PAG 121, Irgacure PAG 203, Irgacure PAG 290, Irgacure CGI 725, Irgacure CGI 1380, Irgacure CGI 1907 und Irgacure GSID 26-1 der Firma BASF.

Dem Fachmann sind weitere Systeme bekannt, die ebenfalls erfindungsgemäß einsetzbar sind. Photoinitiatoren werden unkombiniert oder als Kombination von zwei oder mehreren Photoinitiatoren eingesetzt.

Vorteilhaft sind Photoinitiatoren, die Absorption bei kleiner 350 nm und vorteilhaft bei größer 250 nm aufweisen. Initiatoren, die oberhalb 350 nm absorbieren, beispielsweise im Bereich violetten Lichts, sind ebenfalls einsetzbar. Sulfonium-basierende Photoinitiatoren werden besonders bevorzugt eingesetzt, da sie eine vorteilhafte UV-Absorptionscharakteristik aufweisen.

### Thermische Initiatoren für die kationische Polymerisation von Epoxiden

Thermische Initiatoren, sogenannte thermischen Säurebildner ("thermal acid generator" TAG) sind beispielsweise Benzylthiolaniumsalze mit beispielsweise PF₆⁻ , AsF₆⁻, oder SBF₆⁻ Anionen beschrieben in US 5,242,715 A, BF₃-Amin-Komplexe, beschrieben in "Study of Polymerization Mechanism and Kinetics of DGEBA with BF₃-amine Complexes Using FT-IR and Dynamic DSC" (Ghaemy et al., Iranian Polymer Journal, Vol. 6, No. 1, 1997), Lanthanid Triflate beschrieben in "Study of Lanthanide Triflates as New Curing Initiators for Cycloaliphatic Epoxy Resins" (C. Mas et al., Macromolecular Chemistry and Physics, 2001, 202, No. 12) oder geblockte Supersäuren wie beispielsweise Ammonium triflate; Ammonium perfluorobutanesulfonate (PFBuS); Ammonium Ad-TFBS [4-adaman-tanecarboxyl-1,1,2,2-tetrafluorobutane sulfonate]; Ammonium AdOH-TFBS [3-hydroxy-4-adamantanecarboxyl-1,1,2,2-tetrafluorobutane sulfonate]; Ammonium Ad-DFMS [Adamantanyl-methoxycarbonyl)-difluoromethanesulfonate]; Ammonium AdOH-DFMS [3-Hydroxyadamantanyl-methoxycarbonyl)-difluoromethanesulfonate]; Ammonium DHC-TFBSS [4-dehydrocholate-1,1,2,2-tetrafluorobutanesulfonate]; and Ammonium ODOT-DFMS [Hexahydro-4,7-Epoxyisobenzofuran-1(3H)-one, 6-(2,2'-difluoro-2-sulfonatoacetic acid ester)].

Kommerziell sind solche Systeme z.B. von King Industries unter den Bezeichnungen TAG-2678, TAG-2713 oder TAG-2172 zu erhalten. Diese geblockten Säuren setzen bei erhöhten Temperaturen beispielsweise Trifluoromethansulfonsäure, p-Toluolsulfonsäure oder Dodecylbenzyl Sulfonsäure frei, die eine kationische Härtung von Epoxiden initiieren.

Zusätzlich zu den thermischen und photochemischen Initiatoren sind besonders bevorzugte Initiatioren für die Polymerisationsreaktion zur Herstellung der Epoxid-Sirupe, wie bereits ausgeführt, elektronenarme Mono-Isocyanate wie beispielsweise p-Tolyl isocyanat, p-Toluolsulfonylmethylisocyanat, o-Tolylisocyanat oder o-Toluolsulfonylmethylisocyanat. Insbesondere bevorzugt sind Derivate von Sulfonylisocyanaten (R-SO₂-NCO, R-SO₂-CH₂-NCO) wie beispielsweise 4-Chlorbenzylsulfonylisocyanat, o-Toluolsulfonylisocyanat, p-Toluolsulfonylisocyanat, Benzylsulfonylisocyanat.

### Beispiele

### Messmethoden

### Viskositätsmessung:

Ein Maß für die Fließfähigkeit des fluiden Beschichtungsmaterials ist die dynamische Viskosität. Die dynamische Viskosität kann nach DIN 53019 bestimmt werden. Als Fluid wird eine Viskosität von weniger als 10⁸ Pa·s bezeichnet. Die Viskosität wird in einem Zylinderrotationsviskosimeter mit einer Standardgeometrie nach DIN 53019-1 bei einer Messtemperatur von 23°C und einer Schergeschwindigkeit 1 s⁻¹ gemessen.

### Molekulargewichtsverteilung:

Die Molekulargewichtsbestimmungen der zahlenmittleren Molekulargewichte Mₙ und der gewichtsmittleren Molekulargewichte M_{w} erfolgten mittels Gelpermeationschromatographie (GPC). Als Eluent wurde THF (Tetrahydrofuran) mit 0,1 Vol.-% Trifluoressigsäure eingesetzt. Die Messung erfolgte bei 25 °C. Als Vorsäule wurde PSS-SDV, 10 µ, ID 8,0 mm x 50 mm verwendet. Zur Auftrennung wurden die Säulen PSS-SDV, 10 µ ID 8,0 mm x 300 mm eingesetzt. Die Probenkonzentration betrug 1,5 g/l, die Durchflussmenge 0,5 ml pro Minute. Es wurde gegen Poly(methyl-methacrylat)-Standards gemessen.

Die Angaben der zahlenmittleren Molmasse Mₙ, der gewichtsmittleren Molmasse M_{w} und der Polydispersität in dieser Schrift beziehen sich auf die Bestimmung per Gelpermeationschromatographie (GPC) bzw. die Auswertung derartiger Messungen.

### Permeationsmessung (WVTR):

Die WVTR wird bei 38°C und 90% relativer Luftfeuchtigkeit nach ASTM F-1249 gemessen. Es wird jeweils eine Doppelbestimmung durchgeführt und der Mittelwert gebildet. Der angegebene Wert ist auf eine Dicke von 50 µm normiert.

Die Transferklebebänder wurden für die Messungen auf eine hochpermeable Polysulfon-Membran (erhältlich von der Firma Sartorius) geklebt, die selbst keinen Beitrag zur Permeationsbarriere liefert.

### Klebkraft:

Die Klebkräfte auf Glas wurden analog ISO 29862 (Methode 3) bei 23 °C und 50 % relativer Luftfeuchte bei einer Abzugsgeschwindigkeit von 30 mm/min bzw. 3mm/min und einem Abzugswinkel von 180° bestimmt. Als Verstärkungsfolie wurde eine geätzte PET-Folie mit einer Dicke von 50 µm verwendet, wie sie von der Fa. Coveme (Italien) erhältlich ist. Die Verklebung des Messtreifens wurde dabei mittels einer Anrollmaschine bei einer Temperatur von 23 °C vorgenommen. Die Klebebänder wurden sofort nach der Applikation abgezogen. Der Messwert (in N/cm) ergab sich als Mittelwert aus drei Einzelmessungen.

### Lebensdauertest:

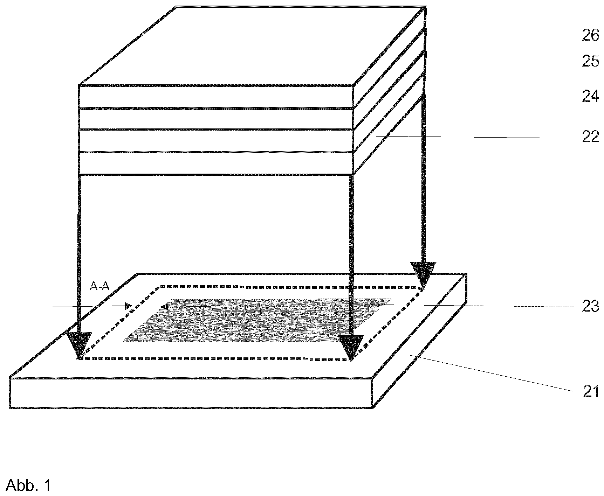

Als ein Maß für die Bestimmung der Lebensdauer eines elektronischen Aufbaus wurde ein Calciumtest herangezogen. Dieser ist in der Figur 1 gezeigt. Dazu wird im Vakuum eine 10 x 10 mm² große, dünne Calciumschicht 23 auf eine Glasplatte 21 abgeschieden und danach unter Stickstoffatmosphäre gelagert. Die Dicke der Calciumschicht 23 liegt bei etwa 100 nm. Für die Verkapselung der Calciumschicht 23 wird ein Klebeband (23 x 23 mm²) mit der zu testenden Klebemasse 22 sowie einer Dünnglasscheibe 24 (30 µm, Firma Schott) als Trägermaterial verwendet. Zur Stabilisierung war die Dünnglasscheibe mit einer 100 µm dicken PET-Folie 26 mittels eines 50 µm dicken Transferklebebands 25 einer optisch hochtransparenten Acrylathaftklebemasse laminiert. Die Klebemasse 22 wird so auf der Glasplatte 21 appliziert, dass die Klebemasse 22 den Calciumspiegel 23 mit einem allseitig überstehenden Rand von 6,5 mm (A-A) abdeckt. Aufgrund des undurchlässigen Glasträgers 24 wird nur die Permeation durch den Haftkleber oder entlang der Grenzflächen ermittelt.

Der Test basiert auf der Reaktion von Calcium mit Wasserdampf und Sauerstoff, wie sie beispielsweise von A.G. Erlat et. al. in "47th Annual Technical Conference Proceedings-Society of Vacuum Coaters", 2004, Seiten 654 bis 659, und von M. E. Gross et al. in "46th Annual Technical Conference Proceedings-Society of Vacuum Coaters", 2003, Seiten 89 bis 92, beschrieben sind. Dabei wird die Lichttransmission der Calciumschicht überwacht, welche durch die Umwandlung in Calciumhydroxid und Calciumoxid zunimmt. Diese erfolgt beim beschriebenen Prüfaufbau vom Rand her, so dass sich die sichtbare Fläche des Calciumspiegels verringert. Es wird die Zeit bis zur Halbierung der Lichtabsorption des Calciumspiegels als Lebensdauer bezeichnet, die Zeit bis zum Einsetzen einer stetigen Abnahme der Absorption als Durchbruchzeit oder "lag-time". Durch die Methode werden dabei sowohl der Abbau der Fläche des Calciumspiegels vom Rand aus und durch punktuellen Abbau in der Fläche als auch die homogene Verringerung der Schichtdicke des Calciumspiegels durch vollflächigen Abbau erfasst.

Als Messbedingungen wurden 85 °C und 85 % relative Luftfeuchte gewählt. Die Muster wurden mit einer Schichtdicke der Haftklebemasse von 50 µm vollflächig und blasenfrei verklebt. Die Messungen wurden an vernetzten Klebebändern vorgenommen. Der Messwert (in h) ergab sich als Mittelwert aus drei Einzelmessungen.

Aus der Zeit bis zum vollständigen Abbau des Calciumspiegels wird zudem eine Wasserdampfpermeationsrate (Ca-WVTR) berechnet. Dazu wird die Masse des aufgedampften Calciums mit dem Faktor 0.9 multipliziert (Massenverhältnis H₂O/Ca für die Umsetzungsreaktion von metallischem Calcium zu transparentem Calciumhydroxid) um die Masse des einpermeierten Wasserdampfes zu ermitteln. Diese wird auf den Permeationsquerschnitt (Umfangslänge des Testaufbaus x Klebemassedicke) sowie die Zeit bis zum vollständigen Abbau des Calciumspiegels bezogen. Der errechnete Messwert wird weiterhin durch die Breite des allseitig überstehenden Rands (in mm) geteilt und somit auf eine Permeationsstrecke von 1 mm normiert. Die Angabe des Ca-WVTR erfolgt in g/m^{2*}d.

**Verwendete Materialien:**

| | |
|---|---|
| Uvacure 1500 | cycloaliphatisches Diepoxid der Firma Cytec ((3,4-epoxycyclohexane)methyl 3,4-epoxycyclohexylcarboxylate) |
| Polyacrylat | Acrylatcopolymer aus 2-Hydroxyethylacrylat, 2 Ethylhexylacrylat und C-17-Acrylat, Mₙ = 884000 g / mol |
| Uvacure Sirup | detaillierte Herstellanweisung siehe unten |
| Escorez 5300 | ein vollhydriertes Kohlenwasserstoffharz der Firma Exxon |
| | (Ring and Ball 105 °C, DACP = 71, MMAP = 72) |
| Sibstar 62M | SiBS (Polystyrol-block-Polyisobutylen-Blockcopolymer) der Firma Kaneka mit 20 Gew.-% Blockpolystyrolgehalt. Enthält zum Teil auch Diblockcopolymere. |
| p-Toluolsulfonylisocyanat | Elektronenarmes Mono-Isocyanat |
| Triarylsulfoniumhexa-fluoroantimonat | kationischer Fotoinitiator von der Firma Sigma-Aldrich |
| | Der Photoinitiator weist ein Absorptionsmaximum im Bereich 320 nm bis 360 nm auf und lag als 50 Gew.-%-ige Lösung in Propylencarbonat vor |

Das Polyacrylat wurde nach folgender Vorschrift hergestellt:
Ein für radikalische Polymerisationen konventioneller 2 L Glasreaktor wurde mit 40 g 2-Hydroxyethylacrylat, 240 g 2 Ethylhexylacrylat, 120 g C17-Acrylat (dreifach verzweigte Seiten mit C3- C4 Kettensegmenten, BASF SE), 133 g Siedegrenzbenzin 69/95 und 133 g Aceton befüllt. Nachdem 45 Minuten Stickstoffgas unter Rühren durch die Reaktionslösung geleitet worden war, wurde der Reaktor auf 58 °C geheizt und 0,2 g Vazo 67 (Fa. DuPont) hinzugegeben. Anschließend wurde das äußere Heizbad auf 75°C erwärmt und die Reaktion konstant bei dieser Außentemperatur durchgeführt. Nach 1 h Reaktionszeit wurden 50 g Toluol hinzugegeben. Nach 2.5 h wurde mit 100 g Aceton verdünnt. Nach 4 h Reaktionszeit wurden nochmals 0,2 g Vazo 67 hinzugegeben. Nach 7 h Polymerisationszeit wurde mit 100 g Siedegrenzbenzin 60/95, nach 22 h mit 100 g Aceton verdünnt. Nach 24 h Reaktionszeit wurde die Polymerisation abgebrochen und das Reaktionsgefäß auf Raumtemperatur abgekühlt. Das Molekulargewicht Mₙ betrug 884000 g/mol.

### Herstellung der Uvacure-Sirupe:

### Initiation mit elektronenarmen Mono-Isocyanaten:

In einem 2I-Polymerisationsreaktor wurden 1kg Uvacure 1500 sowohl unter Stickstoff Atmosphäre als auch ohne Schutzgas auf 85°C erwärmt. Die Viskosität des Uvacure 1500 beträgt 0,25 Pa s. Im Stickstoffgegenstrom wurde der Initiator zugegeben und die Lösung langsam gerührt.

Zur Ermittlung der Molekulargewichtsverteilungen und Viskositäten wurden während der Reaktion nach unterschiedlichen Reaktionszeiten Proben gezogen und mittels GPC und Viskosimetrie analysiert.

**Tabelle 1: GPC-Ergebnisse von erfindungsgemäßen Epoxid-Sirupen initiiert mit elektronenarmem Mono-Isocyanat**

| **TSI Menge** | **Mw** | **Mn** | **D** | **Reaktionszeit** | **Temperatur** |
|---|---|---|---|---|---|
| [%] | [g mol⁻¹] | [g mol⁻¹] | | [h] | [°C] |
| 6 | 13500 | 780 | 17,4 | 3,25 | 100 |
| 6 | 11100 | 740 | 15,1 | 4,25 | 100 |
| 6 | 22000 | 790 | 27,9 | 5,25 | 100 |
| 7 | 22500 | 830 | 27,3 | 1,0 | 100 |
| 7 | 59700 | 830 | 71,7 | 2,25 | 100 |
| 7 | 78400 | 850 | 92 | 3,75 | 100 |
| 7,4 | 5100 | 630 | 8 | 0,5 | 100 |
| 7,4 | 6000 | 600 | 9,9 | 1 | 100 |
| 7,4 | 16100 | 650 | 24,8 | 3,3 | 100 |

Es zeigt sich, dass die Polydispersität mit zunehmender Reaktionszeit ebenfalls zunimmt.

**Tabelle 2: Viskositäten von erfindungsgemäßen Epoxid-Sirupen initiiert mit TSI**

| **TSI Menge** [%] | **Reaktionszeit [min]** | **Viskosität [Pa s]** |
|---|---|---|
| 6 | 30 | 10,9 |
| 6 | 60 | 40 |
| 6 | 90 | 67,2 |
| 6 | 130 | 132 |
| 6 | 180 | 203 |
| 6 | 230 | 334 |
| 7 | 30 | 39,6 |
| 7 | 60 | 115 |
| 7 | 90 | 230 |
| 7 | 120 | 420 |
| 7 | 190 | 1536 |
| 7 | 210 | 1956 |

Auch aus der Tabelle 2 lässt sich gut erkennen, dass die Reaktion mit höherer Initiatormenge deutlich schneller verläuft und ein Viskositätsanstieg sehr viel schneller erreicht wird.

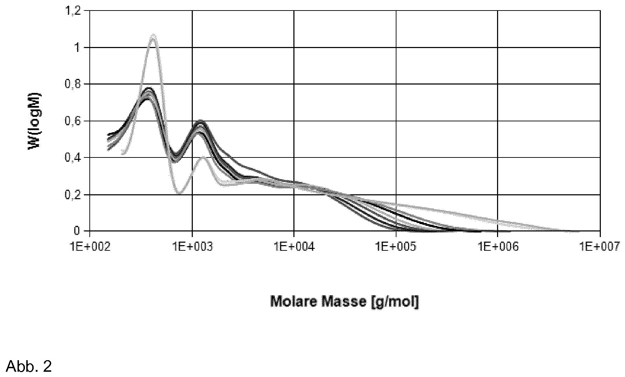

Abbildung 2 zeigt die Molekulargewichtsverteilung von über unterschiedlich lange Zeiträume polymerisierten Uvacure-Sirupen. Markant ist die enorm breite Verteilung, die viele Moleküle kleiner 1.000 g/mol enthält, aber auch bis zum Teil über 10⁶ g/mol große Ketten, die die hohe Viskosität bewirken.

### Inititation mit hochverdünnten Photoinitiatoren

In einem 2I-Glasreaktor wurden zu 1kg Epon Resin 828 unter Lichtausschluss und unter Stickstoffatmosphäre bei 23°C ein Photoinitiator (Triarylsulfoniumhexafluoroantimonat) unter Rühren (50 U/Min) zugegeben. Die Initiation der Reaktion erfolgte durch 2 minütige Bestrahlung mit 4 Hg-Mitteldrucklampen, die radial um den Polymerisationsreaktor positioniert waren.

Zur Ermittlung der Viskositäten wurden während der Reaktion nach unterschiedlichen Reaktionszeiten Proben gezogen und mittels GPC und Viskosimetrie analysiert.

**Tabelle 3: Viskositäten von erfindungsgemäßen Epoxid-Sirupen initiiert mit Triarylsulfoniumhexafluoroantimonat**

| Photoinitiatormenge [%] | Viskosität nach 120h [mPa s] |
|---|---|
| 0,004 | 500 |
| 0,01 | 860 |
| 0,02 | 1300 |

Es ist erkennbar, dass deutlich geringere Initiatormengen erforderlich sind und die Viskositäten bei gleicher Reaktionszeit mit zunehmender Initiatormenge ebenfalls zunehmen.

**Tabelle 4: Für Klebmassenformulierungen verwendete Uvacure Sirupe**

| **Bezeichnung** | **Viskosität / Pa s** |
|---|---|
| Uvacure Sirup 1 | 21 |
| Uvacure Sirup 2 | 60 |
| Uvacure Sirup 3 | 203 |
| Uvacure Sirup 4 | 392 |
| Uvacure Sirup 5 | 1544 |
| Uvacure Sirup 6 | 3016 |

### Klebmassenzusammensetzungen

Als Copolymer wurde ein Polystyrol-block-Polyisobutylen Blockcopolymer der Firma Kaneka ausgewählt. Der Anteil an Styrol im Gesamtpolymer beträgt 20 Gew.-%. Es wurde Sibstar 62M verwendet. Die Molmasse M_{w} beträgt 60.000 g/mol. Die Glasübergangstemperatur der Polystyrolblöcke betrug 100 °C und die der Polyisobutylenblöcke -60 °C. Als Klebharz kam Escorez 5300 (Ring and Ball 105 °C, DACP = 71, MMAP = 72) der Firma Exxon, ein vollhydriertes Kohlenwasserstoffharz zum Einsatz. Als Reaktivharz wurden unterschiedliche Uvacure Sirupe ausgewählt. Diese Rohstoffe wurden in einem Gemisch aus Toluol (300 g), Aceton (150 g) und Siedegrenzenbenzin 60/95 (550 g) gelöst, so dass eine 50 Gew.-% Lösung entsteht.

Anschließend wurde der Lösung ein Photoinitiator zugesetzt. Der Photoinitiator lag als 50 Gew.-%ige Lösung in Propylencarbonat vor. Der Photoinitiator weist ein Absorptionsmaximum im Bereich 320 nm bis 360 nm auf.

Zur Herstellung von Klebemasseschichten wurden verschiedene Klebemassen aus einer Lösung auf einen konventionellen Liner (silikonisierte Polyesterfolie) mittels eines Laborstreichgeräts aufgebracht und getrocknet. Die Klebemassenschichtdicke nach dem Trocknen beträgt 50±5 µm. Die Trocknung erfolgte jeweils zunächst bei RT für 10 Minuten und 10 Minuten bei 120 °C in einem Labortrockenschrank. Die getrockneten Klebemasseschichten wurden jeweils unverzüglich nach dem Trocknen mit einem zweiten Liner (silikonisierte Polyesterfolie mit geringerer Trennkraft) auf der offenen Seite laminiert.

Die Muster wurden in eine Glove-Box eingeschleust. Ein Teil der Muster wurde auf einem mit Ca bedampften Glassubstrat mit einem Gummianroller blasenfrei laminiert. Darauf wurde der zweite PET-Liner ausgedeckt und eine Lage eines Dünnglases auflaminiert. Anschließend wurde durch das Abdeckglas mittels UV-Licht bestrahlt (Dosis: 80 mJ/cm²; Lampentyp: undotierter Quecksilberstrahler). Dieses Muster wurde für den Lebensdauertest verwendet.

Die genaue Zusammensetzung der einzelnen Beispiele K1 bis K10 bzw. V1 sowie K1 Basis und V1 Basis ist der Tabelle 5 zu entnehmen.

**Tabelle 5: Zusammensetzung der Beispiele**

| **Beispiel:** | **K1-6** | **K7** | **K8** | **K9** | **K10** | **V1** | **K1 Basis** | **V1 Basis** |
|---|---|---|---|---|---|---|---|---|
| | Gew.-Anteil | Gew.-Anteil | Gew.-Anteil | Gew.-Anteil | Gew.-Anteil | Gew.-Anteil | Gew.-Anteil | Gew.-Anteil |
| Sibstar 62M | 20 | 37,5 | 25 | 17,5 | 10 | - | 50 | |
| Uvacure 1500 | 0 | 0 | 0 | 0 | 0 | - | - | |
| Uvacure Sirup 1-6 | 60 | 0 | 0 | 0 | 0 | | 0 | |
| Uvacure Sirup 5 | | 25 | 50 | 65 | 80 | 50 | | |
| Polyacrylat | | | | | | 50 | | 100 |
| Escorez 5300 | 20 | 37,5 | 25 | 17,5 | 10 | - | 50 | |
| Triarylsulfoniumhexafluoroantimonat | 0,1 | 0,1 | 0,1 | 0,1 | 0,1 | 0,1 | | |

Dabei sind die Beispiele K1 bis K6 die Klebmassen unter Verwendung der in der Tabelle 4 aufgeführten Uvacure-Sirupe 1 bis 6, d.h. es handelt sich um Klebmassen mit den gleichen Anteilen der einzelnen Verbindungen, die sich lediglich in der Viskosität des Uvacure-Sirups unterscheiden. Beispiele K7 bis K10 verwenden den Uvacure-Sirup 5 der Tabelle 4 in unterschiedlichen Gewichtsanteilen. V1 (Klebemasse mit 50 Gew.-% Acrylat) sowie K1 Basis (Blockcopolymer mit Klebharz ohne Epoxidsirup) und V1 Basis (reines Acrylat) sind Vergleichsbeispiele.

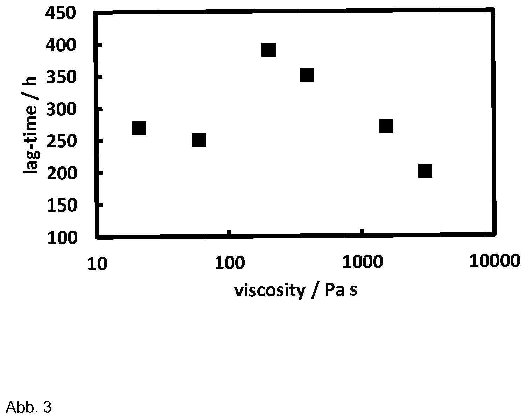

Abb. 3 zeigt die Durchbruchszeit oder lag-time der Klebmassen K1-K6 (Anteil von 60 Gew.-% des Epoxidsirups) in Abhängigkeit der Viskosität der verwendeten Uvacure Sirupe. Es ist ersichtlich, dass besonders bevorzugte Viskositäten der eingesetzten Epoxidsirupe im Bereich von 100 - 1000 Pa s liegen.

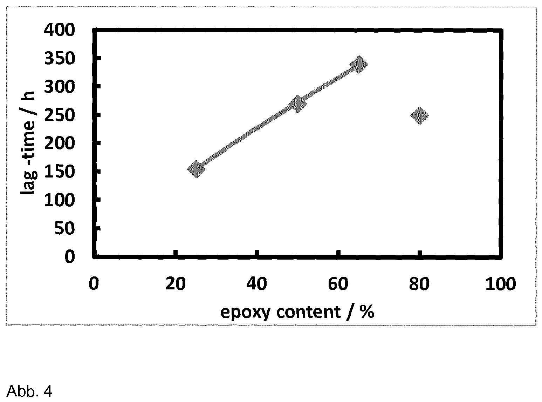

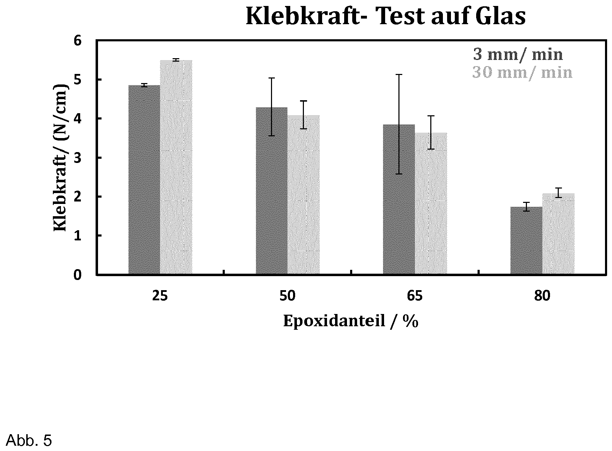

Abb. 4 zeigt die lag-time Ergebnisse von Lagerungsversuchen bei 85°C / 85% r.F. (relative Luftfeuchte) in Abhängigkeit der Epoxidmenge (K7-K10). Es ist ersichtlich, dass die Durchbruchzeit mit zunehmendem Epoxidgehalt zunächst ansteigt und zwischen 60 Gew.-% und 80 Gew.-% Epoxidgehalt ein Maximum hat. Bei einem noch höheren Epoxidgehalt von 80 Gew.-% nimmt die Durchbruchzeit wieder ab, was vermutlich dadurch bedingt ist, dass die Klebkraft wie in Abb. 5 dargestellt deutlich zurückgeht und somit Wasser entlang der Grenzfläche permeiert.

In Abb. 5 sind die Klebkraftmessungen von Klebmassen auf Glas mit unterschiedlichen Epoxidgehalten (K7-K10) veranschaulicht. Aus der Abbildung geht hervor, dass die Klebkrafteigenschaften mit zunehmendem Epoxidanteil kontinuierlich abnehmen. Daraus und aus den Ergebnissen der Barriereeigenschaften geht hervor, dass besonders ausgewogene Barriereklebmassen 50-75% Epoxid-Sirup enthalten.

Schließlich sind in Tabelle 6 die Durchbruchszeiten in Abhängigkeit der WVTR-Werte für verschiedene Klebmassen gegenübergestellt.

**Tabelle 6: lag-time in Abhängigkeit der WVTR**

| | **K1 Basis** | **V1 Basis** | **K8** | **V1** |
|---|---|---|---|---|
| **WVTR / g m⁻²d⁻¹** | 7 | 673 | 17 | 239 |
| **lag-time (85°C/85%r.F.) / h** | 8 | 0 | 270 | 10 |

Aus der Tabelle geht hervor, dass die Klebmassen außer V1 sehr niedrige WVTR-Werte haben. Vergleicht man diese Ergebnisse mit den erzielten Barriereeigenschaften, so ist festzustellen, dass lediglich die erfindungsgemäße Masse mit weniger als 100g/m²d (K8) eine gute lag-time aufweist.

## Patentansprüche

1. Wasserdampfsperrende Klebemasse, enthaltend
eine Klebstoffbasis aus
- mindestens einem Epoxidsirup
- mindestens einem Elastomer
- mindestens einem Initiator
- optional mindestens einem Klebharz,
- optional mindestens einem weiteren Reaktivharz
optional ein Lösungsmittel,
**dadurch gekennzeichnet, dass** die Klebstoffbasis ohne Lösungsmittel eine Wasserdampfpermeationsrate nach der Aktivierung der Reaktivharzkomponente von weniger als 100 g/m²d aufweist, gemessen bei 38 °C und 90% relativer Luftfeuchtigkeit nach ASTM F-1249 und normiert auf eine Dicke von 50 µm, wobei der Epoxidsirup bis-Epoxidmonomere und aus diesen erzeugte hochmolekulare unvernetzte Polyepoxide enthält, und eine Viskosität von mindestens 1 Pa s aufweist, gemessen nach DIN 53019 in einem Zylinderrotationsviskosimeter mit einer Standardgeometrie nach DIN 53019-1 bei einer Messtemperatur von 23 °C und einer Schergeschwindigkeit von 1 s⁻¹.

2. Wasserdampfsperrende Klebemasse nach Anspruch 1, **dadurch gekennzeichnet, dass** die Klebstoffbasis ohne Lösungsmittel eine Wasserdampfpermeationsrate nach der Aktivierung der Reaktivharzkomponente von weniger als 60 g/m²d, insbesondere weniger als 30 g/m²d aufweist, jeweils gemessen bei 38 °C und 90% relativer Luftfeuchtigkeit nach ASTM F-1249 und normiert auf eine Dicke von 50 µm.

3. Wasserdampfsperrende Klebemasse nach Anspruch 1 oder 2, **dadurch gekennzeichnet, dass**
die Viskosität des Epoxidsirups mindestens doppelt so hoch ist, vorzugsweise mindestens viermal so hoch und insbesondere mindestens zehnmal so hoch ist wie die des ursprünglichen bis-Epoxidmonomeres.

4. Wasserdampfsperrende Klebemasse nach einem der Ansprüche 1 bis 3, **dadurch gekennzeichnet, dass** der Epoxidsirup in einer Menge von 10 bis 80 Gew.-%, vorzugsweise von 20 bis 75 Gew.-%, insbesondere von 35 bis 70 Gew.-% in der Klebstoffbasis enthalten ist.

5. Wasserdampfsperrende Klebemasse nach einem der Ansprüche 1 bis 4, **dadurch gekennzeichnet dass**
der Epoxidsirup eine breite Molgewichtsverteilung der Bestandteile von 2.000 g/mol durchgehend bis mindestens 100.000 g/mol aufweist, bestimmt mittels Gelpermeationschromatographie, wobei als Eluent Tetrahydrofuran mit 0,1 Vol. % Trifluoressigsäure eingesetzt wird, die Messung bei 25 °C erfolgt und gegen Poly(methylmethacrylat)-Standards gemessen wird.

6. Wasserdampfsperrende Klebemasse nach einem der Ansprüche 1 bis 5, **dadurch gekennzeichnet dass** in dem Epoxidsirup im unvernetzten Zustand mindestens 65%, bevorzugt mindestens 75%, insbesondere mindestens 80% der ursprünglichen Epoxidgruppen noch vorhanden sind.

7. Wasserdampfsperrende Klebemasse nach einem der Ansprüche 1 bis 6, **dadurch gekennzeichnet, dass** die bis-Epoxidmonomere bis-Epoxycyclohexyl-Derivate oder Epoxide auf Basis von Bisphenol-A, Bisphenol-S oder Bisphenol-F sind.

8. Wasserdampfsperrende Klebemasse nach einem der Ansprüche 1 bis 7, **dadurch gekennzeichnet, dass** die Epoxidmonomere Bis-Epoxycyclohexyl-Derivate, insbesondere 3,4-Epoxycyclohexylmethyl-3,4-epoxycyclohexancarboxylat sind.

9. Wasserdampfsperrende Klebemasse nach Anspruch 8, **dadurch gekennzeichnet, dass** die Viskosität des Epoxidsirups mindestens 50 Pa s, bevorzugt zwischen 50-800 Pa s, besonders bevorzugt zwischen 75-500 Pa s und insbesondere zwischen 100-350 Pa s beträgt, jeweils gemessen nach DIN 53019 in einem Zylinderrotationsviskosimeter mit einer Standardgeometrie nach DIN 53019-1 bei einer Messtemperatur von 23 °C und einer Schergeschwindigkeit von 1 s⁻¹.

10. Wasserdampfsperrende Klebemasse nach einem der Ansprüche 1 bis 9, **dadurch gekennzeichnet, dass** der Epoxidsirup durch Anpolymerisieren der bis-Epoxidmonomere erhalten wird.

11. Wasserdampfsperrende Klebemasse nach Anspruch 10, **dadurch gekennzeichnet, dass** das Anpolymerisieren der bis-Epoxidmonomere bei Erreichen einer gewünschten Viskosität durch kontrollierten Abbruch der Polymerisation mittels eines Initiatorfängers beendet wird.

12. Wasserdampfsperrende Klebemasse nach Anspruch 10 oder 11, **dadurch gekennzeichnet, dass** der Initiator für das Anpolymerisieren aus der Gruppe, bestehend aus elektronenarmem Monoisocyanat, Photoinitiator und thermischem Initiator, ausgewählt ist.

13. Wasserdampfsperrende Klebemasse nach Anspruch 11, **dadurch gekennzeichnet**, das elektronenarme Monoisocyanat ausgewählt ist aus der Gruppe, bestehend aus p-Tolylisocyanat, o-Tolylisocyanat und Sulfonylisocyanaten, insbesondere p-Toluolsulfonylmethylisocyanat, o-Toluolsulfonylmethylisocyanat, 4-Chlorbenzylsulfonylisocyanat, o-Toluolsulfonylisocyanat, p-Toluolsulfonylisocyanat und Benzylsulfonylisocyanat, wobei p-Toluolsulfonylisocyanat besonders bevorzugt ist.

14. Wasserdampfsperrende Klebemasse nach einem der Ansprüche 11 bis 13,
**dadurch gekennzeichnet, dass** als Initiatorfänger ein Gemisch aus Wasser und Aceton, Lösungen von (Erd-)Alkalihydroxiden oder Lösungen von (Erd-)Alkali-alkoxiden verwendet wird.

15. Klebeband enthaltend eine wasserdampfsperrende Klebemasse nach einem der Ansprüche 1 bis 14.

16. Verwendung der Klebemasse nach einem der Ansprüche 1 bis 14 oder des Klebebandes nach Anspruch 15 zur Verkapselung von Aufbauten in der organischen Elektronik.

## Claims

1. Adhesive having water vapour barrier properties, comprising
an adhesive base composed of
- at least one epoxy syrup
- at least one elastomer
- at least one initiator
- optionally at least one tackifier resin
- optionally at least one further reactive resin optionally a solvent,
**characterized in that** the adhesive base without solvent has a water vapour permeation rate after activation of the reactive resin component of less than 100 g/m²d, measured at 38°C and 90% relative humidity according to ASTM F-1249 and normalized to a thickness of 50 µm, wherein the epoxy syrup contains bisepoxy monomers and high molecular weight uncrosslinked polyepoxides produced therefrom and has a viscosity of at least 1 Pa s measured according to DIN 53019 in a cylinder-type rotational viscometer having a standard geometry according to DIN 53019-1 at a measurement temperature of 23°C and a shear rate of 1s⁻¹.

2. Adhesive having water vapor barrier properties according to Claim 1, **characterized in that** the adhesive base without solvent has a water vapor permeation rate after activation of the reactive resin component of less than 60 g/m², in particular less than 30 g/m², in each case measured at 38°C and 90% relative humidity according to ASTM F-1249 and normalized to a thickness of 50 µm.

3. Adhesive having water vapour barrier properties according to Claim 1 or 2, **characterized in that** the viscosity of the epoxy syrup is at least twice as high, preferably at least four times as high and in particular at least ten times as high as the viscosity of the original bisepoxy monomer.

4. Adhesive having water vapour barrier properties according to any of Claims 1 to 3, **characterized in that** the epoxy syrup is present in the adhesive base in an amount from 10 to 80 wt%, preferably from 20 to 75 wt%, in particular from 35 to 70 wt%.

5. Adhesive having water vapour barrier properties according to any of Claims 1 to 4, **characterized in that**
the epoxy syrup has a broad molecular weight distribution of the constituents from 2000 g/mol right through to at least 100 000 g/mol, determined by gel permeation chromatography, wherein the eluent employed is tetrahydrofuran comprising 0.1% by volume of trifluoroacetic acid and measurement is carried out at 25°C and against poly (methyl methacrylate) standards.

6. Adhesive having water vapour barrier properties according to any of Claims 1 to 5, **characterized in that** in the epoxy syrup in the uncrosslinked state at least 65%, preferably at least 75%, in particular at least 80%, of the original epoxy groups are still present.

7. Adhesive having water vapour barrier properties according to any of Claims 1 to 6, **characterized in that** the bisepoxy monomers are bisepoxycyclohexyl derivatives or epoxies based on bisphenol-A, bisphenol-S or bisphenol-F.

8. Adhesive having water vapour barrier properties according to any of Claims 1 to 7, **characterized in that** the epoxy monomers are bisepoxycyclohexyl derivatives, in particular 3,4-epoxycyclohexylmethyl-3,4-epoxycyclohexane carboxylate.

9. Adhesive having water vapour barrier properties according to Claim 8, **characterized in that** the viscosity of the epoxy syrup is at least 50 Pa s, preferably between 50-800 Pa s, particularly preferably between 75-500 Pa s and in particular between 100-350 Pa s, in each case measured according to DIN 53019 in a cylinder-type rotational viscometer having a standard geometry according to DIN 53019-1 at a measurement temperature of 23°C and a shear rate of 1s⁻¹.

10. Adhesive having water vapour barrier properties according to any of Claims 1 to 9, **characterized in that** the epoxy syrup is obtained by incipiently polymerizing the bisepoxy monomers.

11. Adhesive having water vapour barrier properties according to Claim 10, **characterized in that** the incipient polymerization of the bisepoxy monomers is brought to an end upon reaching a desired viscosity by controlled termination of the polymerization by means of an initiator scavenger.

12. Adhesive having water vapour barrier properties according to Claim 10 or 11, **characterized in that** the initiator for the incipient polymerization is selected from the group consisting of electron-poor monoisocyanate, photoinitiator and thermal initiator.

13. Adhesive having water vapour barrier properties according to Claim 11, **characterized in that** the electron-poor monoisocyanate is selected from the group consisting of p-tolyl isocyanate, o-tolyl isocyanate and sulphonyl isocyanates, in particular p-toluenesulphonylmethyl isocyanate, o-toluenesulphonylmethyl isocyanate, 4-chlorbenzylsulphonyl isocyanate, o-toluenesulphonyl isocyanate, p-toluenesulphonyl isocyanate and benzylsulphonyl isocyanate, p-toluenesulphonyl isocyanate being particularly preferred.

14. Adhesive having water vapour barrier properties according to any of Claims 11 to 13, **characterized in that** a mixture of water and acetone, solutions of alkali metal/alkaline earth metal hydroxides or solutions of alkali metal/alkaline earth metal alkoxides are used as the initiator scavenger.

15. Adhesive tape comprising an adhesive having water vapour barrier properties according to any of Claims 1 to 14.

16. Use of the adhesive according to any of Claims 1 to 14 or of the adhesive tape according to Claim 15 for encapsulation of assemblies in the field of organic electronics.

## Revendications

1. Masse adhésive formant une barrière à la vapeur d'eau, contenant une base adhésive constituée par
- au moins un sirop d'époxyde,
- au moins un élastomère,
- au moins un initiateur,
- éventuellement au moins une résine adhésive,
- éventuellement au moins une autre résine réactive,
- éventuellement un solvant,
**caractérisée en ce que** la base adhésive sans solvant présente un taux de perméation de la vapeur d'eau, après activation du composant de résine réactive, inférieur à 100 g/m²d, mesuré à 38°C et à une humidité relative de l'air de 90% selon la norme ASTM F-1249 et normalisé par rapport à une épaisseur de 50 µm, le sirop d'époxyde contenant des monomères de bisépoxyde et des polyépoxydes non réticulés de haut poids moléculaire obtenus à partir de ceux-ci et présentant une viscosité d'au moins 1 Pa·s, mesurée selon la norme DIN 53019 dans un viscosimètre rotatif à cylindre présentant une géométrie standard selon la norme DIN 53019-1 à une température de mesure de 23°C et à une vitesse de cisaillement de 1 s⁻¹.

2. Masse adhésive formant une barrière à la vapeur d'eau selon la revendication 1, **caractérisée en ce que** la base adhésive sans solvant présente un taux de perméation de la vapeur d'eau, après activation du composant de résine réactive, inférieur à 60 g/m²d, en particulier inférieur à 30 g/m²d, à chaque fois mesuré à 38°C et à une humidité relative de l'air de 90% selon la norme ASTM F-1249 et normalisé par rapport à une épaisseur de 50 µm.

3. Masse adhésive formant une barrière à la vapeur d'eau selon la revendication 1 ou 2, **caractérisée en ce que** la viscosité du sirop d'époxyde est au moins deux fois plus élevée, de préférence au moins quatre fois plus élevée et en particulier au moins dix fois plus élevée que celle du monomère de bisépoxyde initial.

4. Masse adhésive formant une barrière à la vapeur d'eau selon l'une quelconque des revendications 1 à 3, **caractérisée en ce que** le sirop d'époxyde est contenu dans la base adhésive en une quantité de 10 à 80% en poids, de préférence de 20 à 75% en poids, en particulier de 35 à 70% en poids.

5. Masse adhésive formant une barrière à la vapeur d'eau selon l'une quelconque des revendications 1 à 4, **caractérisée en ce que** le sirop d'époxyde présente une distribution large des poids moléculaires des constituants allant de 2000 g/mole à au moins 100.000 g/mole, déterminée par chromatographie par perméation de gel, du tétrahydrofuranne contenant 0,1% en volume d'acide trifluoroacétique étant utilisé comme éluent, la mesure ayant lieu à 25°C et par rapport au témoin poly(méthacrylate de méthyle).

6. Masse adhésive formant une barrière à la vapeur d'eau selon l'une quelconque des revendications 1 à 5, **caractérisée en ce qu'**au moins 65%, de préférence au moins 75%, en particulier au moins 80% des groupes époxyde initiaux sont encore présents dans le sirop d'époxyde à l'état non réticulé.

7. Masse adhésive formant une barrière à la vapeur d'eau selon l'une quelconque des revendications 1 à 6, **caractérisée en ce que** les monomères de bisépoxyde sont des dérivés de bis-époxycyclohexyle ou des époxydes à base de bisphénol-A, de bisphénol-S ou de bisphénol-F.

8. Masse adhésive formant une barrière à la vapeur d'eau selon l'une quelconque des revendications 1 à 7, **caractérisée en ce que** les monomères d'époxyde sont des dérivés de bis-époxycyclohexyle, en particulier le 3,4-époxycyclohexanecarboxylate de 3,4-époxycyclohexylméthyle.

9. Masse adhésive formant une barrière à la vapeur d'eau selon la revendication 8, **caractérisée en ce que** la viscosité du sirop d'époxyde est d'au moins 50 Pa·s, de préférence est comprise entre 50-800 Pa·s, de manière particulièrement préférée est comprise entre 75-500 Pa·s et en particulier est comprise entre 100-350 Pa·s, à chaque fois mesurée selon la norme DIN 53019-1 dans un viscosimètre rotatif à cylindre présentant une géométrie standard selon la norme DIN 53019-1 à une température de mesure de 23°C et à une vitesse de cisaillement de 1 s⁻¹.

10. Masse adhésive formant une barrière à la vapeur d'eau selon l'une quelconque des revendications 1 à 9, **caractérisée en ce que** le sirop d'époxyde est obtenu par polymérisation partielle des monomères de bisépoxyde.

11. Masse adhésive formant une barrière à la vapeur d'eau selon la revendication 10, **caractérisée en ce que** la polymérisation partielle des monomères de bisépoxyde est arrêtée lorsque qu'ue viscosité souhaitée est atteinte, par interruption contrôlée de la polymérisation au moyen d'un piège d'initiateur.

12. Masse adhésive formant une barrière à la vapeur d'eau selon la revendication 10 ou 11, **caractérisée en ce que** l'initiateur pour la polymérisation partielle est choisi dans le groupe constitué par un mono-isocyanate pauvre en électrons, un photo-initiateur et un initiateur thermique.

13. Masse adhésive formant une barrière à la vapeur d'eau selon la revendication 11, **caractérisée en ce que** le mono-isocyanate pauvre en électrons est choisi dans le groupe constitué par l'isocyanate de p-toluyle, l'isocyanate d'o-toluyle et les isocyanates de sulfonyle, en particulier le méthylisocyanate de p-toluènesulfonyle, le méthylisocyanate d'o-toluènesulfonyle, l'isocyanate de 4-chlorobenzylsulfonyle, l'isocyanate d'o-toluènesulfonyle, l'isocyanate de p-toluènesulfonyle et l'isocyanate de benzylsulfonyle, où l'isocyanate de p-toluènesulfonyle est particulièrement préféré.

14. Masse adhésive formant une barrière à la vapeur d'eau selon l'une quelconque des revendications 11 à 13, **caractérisée en ce qu'**on utilise, comme piège d'initiateur, un mélange d'eau et d'acétone, des solutions d'hydroxydes de métal alcalin(alcalino-terreux) ou des solutions d'alcoxydes de métal alcalin(alcalino-terreux).

15. Ruban adhésif contenant une masse adhésive formant une barrière à la vapeur d'eau selon l'une quelconque des revendications 1 à 14.

16. Utilisation de la masse adhésive selon l'une quelconque des revendications 1 à 14 ou du ruban adhésif selon la revendication 15 pour l'encapsulation de structures en électronique organique.
